# EUROPÄISCHE PATENTANMELDUNG

(11) **EP 3 264 874 A1**
(43) Veröffentlichungstag der Anmeldung: **03.01.2018**
(21) Anmeldenummer: 16176406.3
(22) Anmeldetag: 27.06.2016
(51) Int. Cl.: H05K 7/14, H05K 5/02

(54) **BEFESTIGUNGSSYSTEM UND EIN ZUGEHÖRIGES ARRETIERUNGSVERFAHREN**

(71) Anmelder: Siemens Aktiengesellschaft, 80333 München (DE)
(72) Erfinder: Frühstück, Leo, 1210 Wien (AT)
(74) Vertreter: Maier, Daniel Oliver

(57) **Zusammenfassung**

Die Erfindung bezieht sich auf ein Befestigungssystem mit mehreren Adaptern, bei dem ein erster Adapter (1) zumindest eine erste Nutenlasche (4) mit einer ersten Nut (8) sowie eine zweite Nutenlasche (5) mit einer zweiten Nut (9) aufweist, bei dem ein zweiter Adapter (2) zumindest eine erste Führungslasche (12) mit einem ersten Führungsbolzen (17) sowie eine zweite Führungslasche (13) mit einem zweiten Führungsbolzen (18) und ein dritter Adapter (3) zumindest einen ersten Sicherungsbolzen (22) sowie einen zweiten Sicherungsbolzen (23) aufweist, bei dem in einem zusammengefügten Zustand von erstem und zweitem Adapter (1, 2) jeder Führungsbolzen (17, 18) in der jeweils zugeordneten Nut (8, 9) angeordnet ist, und bei dem die Sicherungsbolzen (22, 23) durch die zugeordneten Nutenlaschen (4, 5) verriegelbar sind.

Dadurch wird der Vorteil erzielt, dass die Zahl der erforderlichen Befestigungsmittel reduziert werden kann und auch bei gelösten Befestigungsmitteln das betreffende Gerät in seiner Position verbleibt.

## Beschreibung

Die Erfindung betrifft ein Befestigungssystem mit einem ersten Adapter, einem zweiten Adapter und einem dritten Adapter, insbesondere für und verbindbar mit einem elektronischen Gerät.

Elektronische Geräte, wie z.B. der Niederspannungsumrichter Siemens SINAMICS S120, weisen an deren Gehäusen häufig Laschen mit Bohrungen auf, die beispielsweise an Ober- oder Unterseiten der Gehäuse angeordnet sein können, und werden über diese Laschen in Geräteschränken gelagert.
Die Geräteschränke weisen ebenfalls Bohrungen auf. Über diese Bohrungen und Schraubenverbindungen wird ein elektronisches Gerät in einen Geräteschrank eingehängt und darin vor unbeabsichtigten Bewegungen gesichert.
Sind keine weiteren Befestigungsmittel bzw.
Haltevorrichtungen vorgesehen, ergibt sich dadurch der Nachteil, dass das elektronische Gerät beispielsweise während eines Montagevorgangs von einem Monteur solange gestützt werden muss, bis die Schraubenverbindungen angezogen sind.
Um eine Erreichbarkeit mit Werkzeugen (z.B. Schraubenziehern) sicherzustellen, d.h. Schrauben anziehen und lösen zu können, müssen diese Laschen exponiert, d.h. über das Gehäuse des elektronischen Geräts auskragend angeordnet sein. Dadurch ergibt sich ein erhöhter Platzbedarf in dem Geräteschrank. Weitere Geräte, die neben dem elektronischen Gerät in dem Geräteschrank gelagert werden, können nicht unmittelbar angrenzend an dieses angeordnet werden, sondern es müssen Abstände eingehalten werden.

Die DE 10 2014 005 708 A1 beschreibt ein modulares Befestigungssystem für Gebäude-Fassadenplatten, bei dem auf einem Befestigungsbeschlag zumindest ein hakenförmiges Verbindungselement angeordnet ist, in das eine formkorrespondierende Verbindungsaufnahme auf der Rückseite einer Fassadenplatte eingehängt wird.

Der Erfindung liegt daher die Aufgabe zugrunde, ein gegenüber dem Stand der Technik verbessertes Befestigungssystem anzugeben.

Erfindungsgemäß wird diese Aufgabe gelöst mit einem Befestigungssystem der eingangs genannten Art,
bei dem der erste Adapter zumindest eine erste Nutenlasche mit einer ersten Nut sowie eine zweite Nutenlasche mit einer zweiten Nut aufweist,
bei dem der zweite Adapter zumindest eine erste Führungslasche mit einem ersten Führungsbolzen sowie eine zweite Führungslasche mit einem zweiten Führungsbolzen aufweist,
bei dem der dritte Adapter zumindest einen ersten Sicherungsbolzen sowie einen zweiten Sicherungsbolzen aufweist,
bei dem in einem zusammengefügten Zustand des ersten Adapters mit dem zweiten Adapter der erste Führungsbolzen in der ersten Nut und der zweite Führungsbolzen in der zweiten Nut angeordnet sind, und
bei dem der zumindest erste Sicherungsbolzen durch die zumindest erste Nutenlasche sowie die zumindest erste Führungslasche und der zweite Sicherungsbolzen durch die zweite Nutenlasche sowie die zweite Führungslasche verriegelbar sind.

Dadurch wird der Vorteil erzielt, dass das insbesondere elektronische Gerät über die erste Nutenlasche, die zweite Nutenlasche, die erste Führungslasche, die zweite Führungslasche, den ersten Sicherungsbolzen sowie den zweiten Sicherungsbolzen in Position gebracht und gehalten, d.h. gegen unbeabsichtigte Bewegungen gesichert wird und die Zahl der erforderlichen Befestigungsmittel (z.B. Schraubenverbindungen) reduziert werden kann.
Dadurch wird eine Reduktion des Montage- und Demontageaufwands erzielt.

Wird das insbesondere elektronische Gerät durch die erste Nutenlasche, die zweite Nutenlasche, die erste Führungslasche, die zweite Führungslasche, den ersten Sicherungsbolzen sowie den zweiten Sicherungsbolzen vertikal in Position gehalten, verbleibt dieses auch bei gelösten Befestigungsmitteln in seiner Position und muss nicht während der gesamten Dauer eines Montage- oder Demontagevorgangs durch einen Monteur oder eine Vorrichtung gestützt werden. Weiterhin sind keine seitlich auskragenden
Befestigungslaschen an einem Gehäuse (z.B. an dessen Ober-, Unterseite, rechter oder linker Seite) des insbesondere elektronischen Geräts für Befestigungsmittel (z.B. Schraubenverbindungen) erforderlich, wodurch sich eine Reduktion des Platzbedarfs für das insbesondere elektronische Gerät in einem Geräteschrank ergibt, d.h. z.B. mehr Geräte pro Volumeneinheit angeordnet werden können.

Eine vorteilhafte Ausgestaltung ergibt sich, wenn auf der zumindest ersten Führungslasche eine erste Ausnehmung und auf der zweiten Führungslasche eine zweite Ausnehmung angeordnet ist, wobei die erste Ausnehmung eine Breite von größer oder gleich dem Durchmesser des zumindest ersten Sicherungsbolzens und die zweite Ausnehmung eine Breite von größer oder gleich dem Durchmesser des zweiten Sicherungsbolzens aufweist. Durch diese Maßnahme wird ein Einklinken des ersten Adapters und des zweiten Adapters in den dritten Adapter ermöglicht.

Es ist günstig, wenn die zumindest erste Nutenlasche, die zweite Nutenlasche, die zumindest erste Führungslasche sowie die zweite Führungslasche hakenförmig ausgebildet sind. Durch diese Maßnahme wird ein Einfädeln des ersten Adapters und des zweiten Adapters in den dritten Adapter erleichtert.

Eine vorteilhafte Lösung erhält man, wenn der erste Adapter zumindest eine erste Sicherungslasche und der zweite Adapter zumindest eine dritte Sicherungslasche aufweist, wobei die zumindest erste Sicherungslasche und die zumindest dritte Sicherungslasche Aufnahmen für ein Befestigungsmittel aufweisen.
Durch diese Maßnahme wird eine Arretierung des Befestigungssystems und des mit ihm verbundenen, insbesondere elektronischen Geräts über Befestigungsmittel (z.B. Schrauben) ermöglicht.

Günstig ist es, wenn der zweite Adapter mit dem insbesondere elektronischen Gerät lösbar verbunden ist.
Durch diese Maßnahme wird ein rascher Tausch (z.B. im Rahmen von Instandhaltungsvorgängen) des Befestigungssystems und des elektronischen Geräts ermöglicht.

Eine vorteilhafte Ausgestaltung erhält man, wenn in einem Bereich zwischen dem ersten Adapter und dem dritten Adapter Leitungen des insbesondere elektronischen Geräts angeordnet sind.
Durch diese Maßnahme wird ein Schutz der Leitungen vor Umgebungseinflüssen, Beschädigungen (z.B. durch Einquetschen etc.) und eine günstige Ausnutzung eines verfügbaren Bauraumbudgets erzielt.

Eine vorteilhafte Lösung wird erzielt, wenn das insbesondere elektronische Gerät ein erstes Profil und ein zweites Profil aufweist, wobei das erste Profil in einer ersten Schiene, die lösbar mit einer zweiten Wand verbunden ist, und das zweite Profil in einer zweiten Schiene, die lösbar mit einer dritten Wand verbunden ist, angeordnet ist.
Durch diese Maßnahme werden das Ein- und Ausführen eines insbesondere elektronischen Geräts in einen Geräteschrank sowie dessen Positionierung in dem Geräteschrank erleichtert.

Eine vorteilhafte Ausgestaltung ergibt sich, wenn mit dem ersten Adapter ein Hebel verbunden ist, der eine Aufnahme für ein Befestigungsmittel aufweist.
Durch diese Maßnahme wird eine Arretierung des Befestigungssystems und des mit ihm verbundenen, insbesondere elektronischen Geräts über das Befestigungsmittel (z.B. eine Schraube) ermöglicht.
Weiterhin werden aufgrund der Funktionalität, den Hebel einzuklappen, permanent auskragende Teile auf dem ersten Adapter vermieden, wodurch z.B. Transportschäden (z.B. ein Abbrechen des Hebels) etc. verhindert werden können.

Eine vorteilhafte Lösung erhält man, wenn der Hebel in einer Signalfarbe ausgeführt ist.
Durch diese Maßnahme wird eine deutliche Indikation des Zustands des Hebels erzielt. Im Gegensatz zu einem eingeklappten Zustand ist in einem ausgelenkten Zustand des Hebels die farbliche Markierung sichtbar und zeigt einem Bediener diesen Zustand an.

Es ist günstig,
wenn der erste Adapter mit dem zweiten Adapter in einer Weise in den dritten Adapter eingeführt wird, dass
am Ende dieses Vorgangs die zumindest erste Nutenlasche an dem zumindest ersten Sicherungsbolzen und die zweite Nutenlasche an dem zweiten Sicherungsbolzen hängt,
wenn der zweite Adapter, der erste Führungsbolzen in der ersten Nut sowie der zweite Führungsbolzen in der zweiten Nut sich in einer Weise bewegen, dass am Ende dieses Bewegungsvorgangs der zumindest erste Sicherungsbolzen zumindest zwischen der zumindest ersten Nutenlasche sowie der zumindest ersten Führungslasche in der ersten Ausnehmung und der zweite Sicherungsbolzen zumindest zwischen der zweiten Nutenlasche sowie der zweiten Führungslasche in der zweiten Ausnehmung angeordnet ist, und
wenn mit einem Befestigungsmittel die zumindest erste Sicherungslasche mit der dritten Sicherungslasche lösbar verbunden wird.
Durch diese Maßnahme wird der Vorgang des Positionierens des insbesondere elektronischen Geräts in einem Geräteschrank von dem Vorgang des Arretierens getrennt. Dadurch wird der Vorteil erzielt, dass z.B. unmittelbar nach dem Einführen des elektronischen Geräts in den Geräteschrank dieses nicht mehr festgehalten werden muss, um die Arretierung mittels Arretierungsmitteln (z.B. Schrauben) durchzuführen.
Auch nach einem Lösen der Arretierungsmittel verbleibt das insbesondere elektronische Gerät auf seiner Position und ist gegen unbeabsichtigte Bewegungen gesichert.

### Nachfolgend wird die Erfindung anhand von

### Ausführungsbeispielen näher erläutert.

Es zeigen beispielhaft:

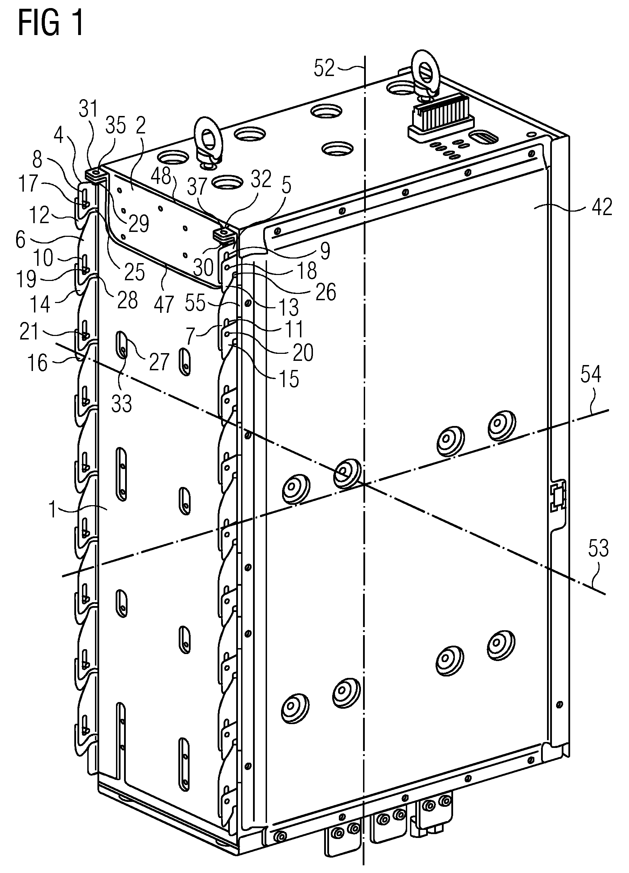

- Fig. 1:: Einen Schrägriss einer ersten beispielhaften Ausführungsvariante eines erfindungsgemäßen Befestigungssystems auf einem elektronischen Gerät, wobei ein erster Adapter und ein zweiter Adapter dargestellt sind,

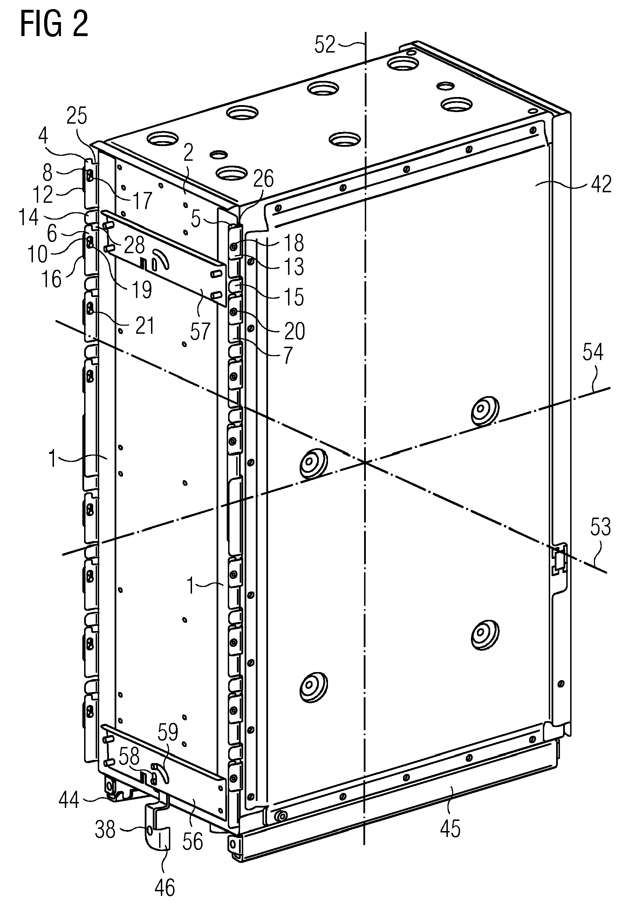

- Fig. 2:: Einen Schrägriss einer zweiten beispielhaften Ausführungsvariante eines erfindungsgemäßen Befestigungssystems auf einem elektronischen Gerät, wobei ein erster Adapter und ein zweiter Adapter dargestellt sind,

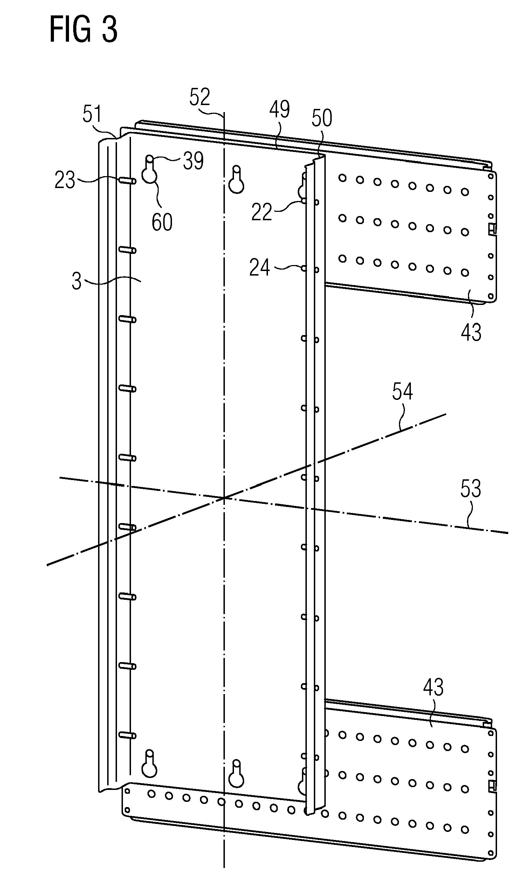

- Fig. 3:: Einen Schrägriss einer beispielhaften Ausführungsvariante eines dritten Adapters eines erfindungsgemäßen Befestigungssystems und ein Teil einer ersten Wand,

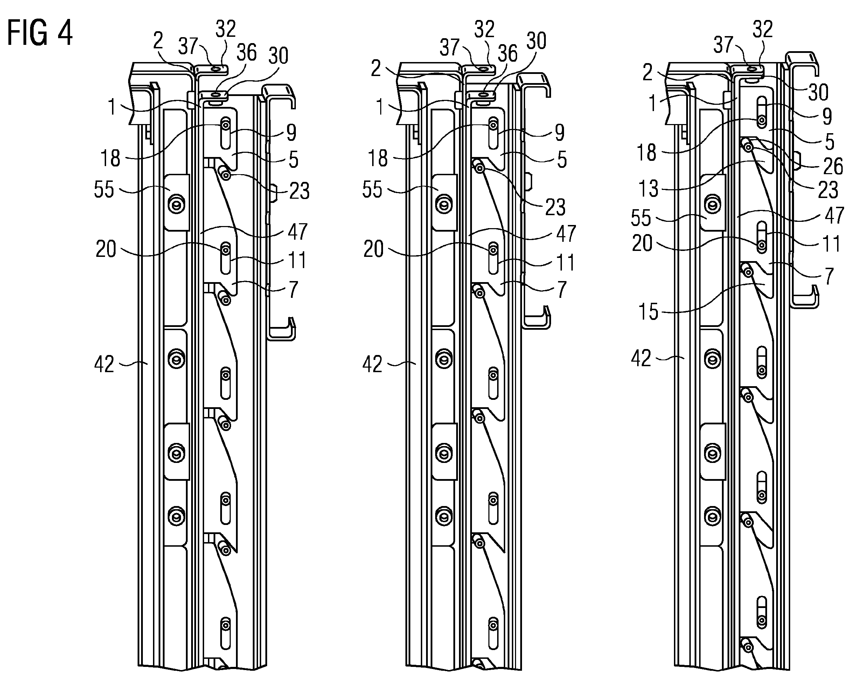

- Fig. 4:: Seitenrisse einer ersten beispielhaften Ausführungsvariante eines erfindungsgemäßen Befestigungssystems, wobei drei Zustände eines beispielhaften erfindungsgemäßen Arretierungsverfahrens sowie jeweils ein erster Adapter, ein zweiter Adapter und Sicherungsbolzen eines dritten Adapters ausschnittsweise gezeigt werden,

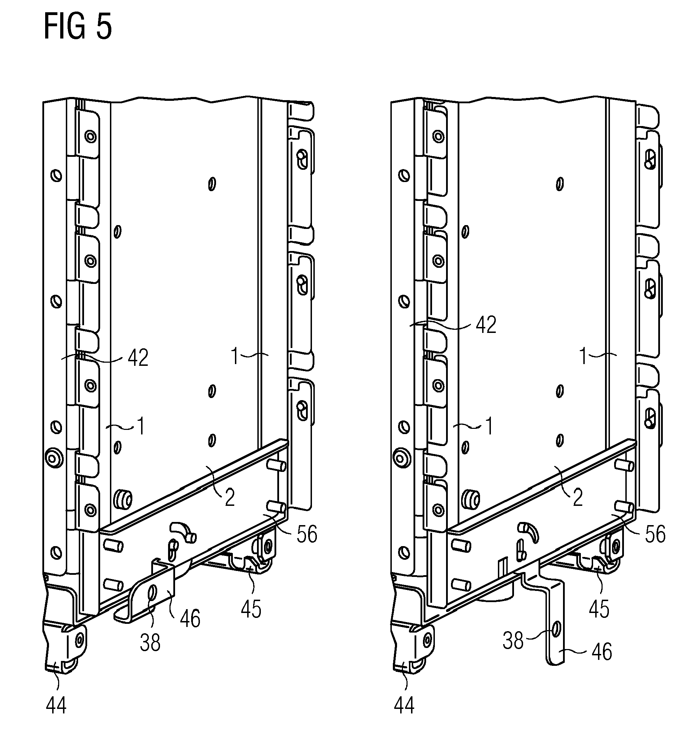

- Fig. 5:: Schrägrisse einer zweiten beispielhaften Ausführungsvariante eines erfindungsgemäßen Befestigungssystems, wobei zwei Zustände eines beispielhaften erfindungsgemäßen Arretierungsverfahrens sowie jeweils ein erster Adapter, ein zweiter Adapter und ein elektronisches Gerät ausschnittsweise sowie ein Hebel gezeigt werden,

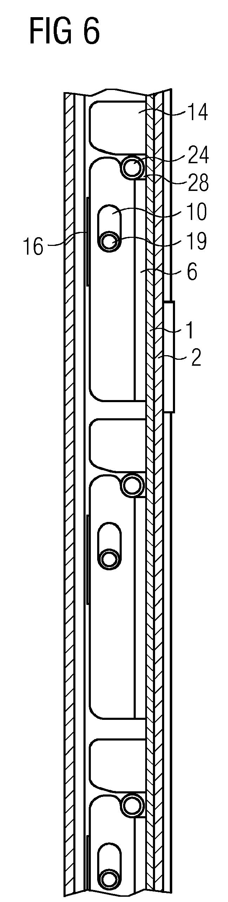

- Fig. 6:: Ein Seitenriss einer zweiten beispielhaften Ausführungsvariante eines erfindungsgemäßen Befestigungssystems, wobei ein Zustand eines beispielhaften erfindungsgemäßen Arretierungsverfahrens sowie ein erster Adapter und ein zweiter Adapter ausschnittsweise sowie Sicherungsbolzen eines dritten Adapters gezeigt werden, und

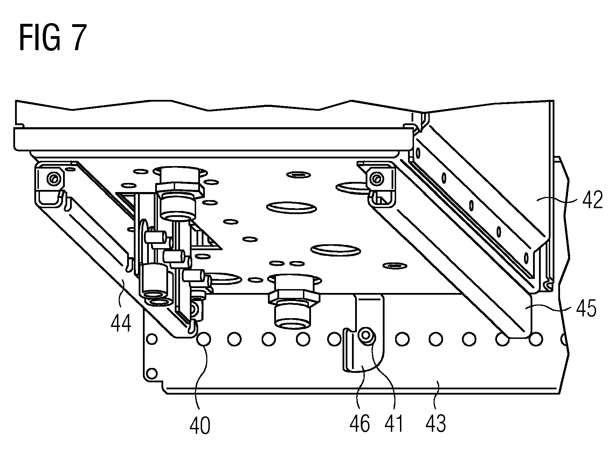

- Fig. 7:: Ein Schrägriss einer zweiten beispielhaften Ausführungsvariante eines erfindungsgemäßen Befestigungssystems, wobei ein Zustand eines beispielhaften erfindungsgemäßen Arretierungsverfahrens sowie ein elektronisches Gerät und eine erste Wand ausschnittsweise sowie ein Hebel dargestellt sind.

Fig. 1 zeigt eine erste beispielhafte Ausführungsvariante eines erfindungsgemäßen Befestigungssystems mit einem ersten Adapter 1 und einem zweiten Adapter 2. Ein in Fig. 3 dargestellter dritter Adapter 3 ist ebenfalls Teil des Befestigungssystems.
Der erste Adapter 1 umfasst eine erste Nutenlasche 4 mit einer ersten Nut 8, eine zweite Nutenlasche 5 mit einer zweiten Nut 9, eine dritte Nutenlasche 6 mit einer dritten Nut 10, eine vierte Nutenlasche 7 mit einer vierten Nut 11 sowie weitere Nutenlaschen mit weiteren Nuten. Die erste Nutenlasche 4, die zweite Nutenlasche 5, die dritte Nutenlasche 6, die vierte Nutenlasche 7 sowie die weiteren Nutenlaschen sind hakenförmig ausgeführt und um 90° zu einer ersten Grundplatte 47 des ersten Adapters 1 abgewinkelt angeordnet.
In Bereichen der ersten Nutenlasche 4, der zweiten Nutenlasche 5, der dritten Nutenlasche 6, der vierten Nutenlasche 7 sowie der weiteren Nutenlaschen, weist der erste Adapter 1 U-förmige Querschnitte auf.
Die erste Nut 8, die zweite Nut 9, die dritte Nut 10, die vierte Nut 11 sowie die weiteren Nuten sind parallel zu einer Hochachse 52 angeordnet.
Über die erste Grundplatte 47 ist der erste Adapter 1 parallel zu einer zweiten Grundplatte 48 des zweiten Adapters 2 und an diese angrenzend ausgerichtet.

Der zweite Adapter 2 umfasst eine hakenförmige erste Führungslasche 12 mit einem ersten Führungsbolzen 17, eine hakenförmige zweite Führungslasche 13 mit einem zweiten Führungsbolzen 18, eine hakenförmige dritte Führungslasche 14 mit einem dritten Führungsbolzen 19, eine hakenförmige vierte Führungslasche 15 mit einem vierten Führungsbolzen 20 sowie weitere hakenförmige Führungslaschen mit weiteren Führungsbolzen, die um 90° abgewinkelt zu der zweiten Grundplatte 48 angeordnet sind.
In Bereichen der ersten Führungslasche 12, der zweiten Führungslasche 13, der dritten Führungslasche 14, der vierten Führungslasche 15 sowie der weiteren Führungslaschen weist der zweite Adapter 2 U-förmige Querschnitte auf.
Der erste Führungsbolzen 17, der zweite Führungsbolzen 18, der dritte Führungsbolzen 19, der vierte Führungsbolzen 20 sowie die weiteren Führungsbolzen sind parallel zu einer Querachse 53 angeordnet.
In Bereichen der ersten Nutenlasche 4, der zweiten Nutenlasche 5, der dritten Nutenlasche 6, der vierten Nutenlasche 7 sowie der weiteren Nutenlaschen grenzen die erste Führungslasche 12, die zweite Führungslasche 13, die dritte Führungslasche 14, die vierte Führungslasche 15 sowie die weiteren Führungslaschen an den ersten Adapter 1.
Der erste Führungsbolzen 17 ist in der ersten Nut 8, der zweite Führungsbolzen 18 in der zweiten Nut 9, der dritte Führungsbolzen 19 in der dritten Nut 10, der vierte Führungsbolzen 20 in der vierten Nut 11 sowie die weiteren Führungsbolzen in den weiteren Nuten angeordnet und können darin in Richtung der Hochachse 52 bewegt werden. Dadurch kann der erste Adapter 1 gegenüber dem zweiten Adapter 2 verschoben werden.
In Fig. 1 wird ein Montagezustand gezeigt, in dem ein nicht dargestellter erster Sicherungsbolzen 22 zwischen der ersten Nutenlasche 4, der ersten Führungslasche 12 und der dritten Nutenlasche 6 in einer auf der ersten Führungslasche 12 ausgebildeten ersten Ausnehmung 25, ein nicht dargestellter zweiter Sicherungsbolzen 23 zwischen der zweiten Nutenlasche 5, der zweiten Führungslasche 13 und der vierten Nutenlasche 7 in einer auf der zweiten Führungslasche 13 ausgebildeten zweiten Ausnehmung 26 sowie weitere nicht dargestellte Sicherungsbolzen zwischen weiteren Nutenlaschen und weiteren Führungslaschen in weiteren Ausnehmungen angeordnet werden können. Ein mit dem zweiten Adapter 2 verbundenes elektronisches Gerät 42 hängt in diesem Montagezustand auf dem ersten Sicherungsbolzen 22, dem zweiten Sicherungsbolzen 23 und den weiteren Sicherungsbolzen.

Der zweite Adapter 2 umfasst eine erste Verbindungslasche 55 sowie weitere Verbindungslaschen, die um 90° abgewinkelt zu der zweiten Grundplatte 48 und um 180° abgewinkelt zu der ersten Führungslasche 12, der zweiten Führungslasche 13, der dritten Führungslasche 14, der vierten Führungslasche 15 sowie den weiteren Führungslaschen angeordnet sind.
Über die erste Verbindungslasche 55 sowie die weiteren Verbindungslaschen und nicht dargestellte
Schraubenverbindungen ist der zweite Adapter 2 mit dem elektronischen Gerät 42 verbunden.
Weiterhin sind auf der zweiten Grundplatte 48 eine erste Bohrung 33 sowie weitere Bohrungen angeordnet, über welche der zweite Adapter 2 über nicht dargestellte Schraubenverbindungen mit dem elektronischen Gerät 42 kraftschlüssig verbunden ist.
Um eine Relativbewegung zwischen dem ersten Adapter 1 und dem zweiten Adapter 2 zu ermöglichen, weist die erste Grundplatte 47 eine ovale dritte Ausnehmung 27 sowie weitere Ausnehmungen auf, in denen nicht dargestellte, in der ersten Bohrung 33 und den weiteren Bohrungen angeordnete Schrauben Relativbewegungen gegenüber dem ersten Adapter 1 ausführen können.

Weiterhin sind auf dem ersten Adapter 1 eine erste Sicherungslasche 29 und eine zweite Sicherungslasche 30 sowie auf dem zweiten Adapter 2 eine dritte Sicherungslasche 31 und eine vierte Sicherungslasche 32 angeordnet. In dem in Fig. 1 gezeigten Montagezustand berührt die erste Sicherungslasche 29 die dritte Sicherungslasche 31 und die zweite Sicherungslasche 30 die vierte Sicherungslasche 32.
Über Aufnahmen, die als eine in Fig. 1 nicht sichtbare zweite Bohrung 34 auf der ersten Sicherungslasche 29 und eine dritte Bohrung 35 auf der dritten Sicherungslasche 31 ausgeführt sind, kann die erste Sicherungslasche 29 mit der dritten Sicherungslasche 31 über eine nicht gezeigte Schraube als Befestigungsmittel kraftschlüssig verbunden werden.

Über Aufnahmen, die als eine in Fig. 1 nicht sichtbare vierte Bohrung 36 auf der zweiten Sicherungslasche 30 und eine fünfte Bohrung 37 auf der vierten Sicherungslasche 32 ausgeführt sind, kann die zweite Sicherungslasche 30 mit der vierten Sicherungslasche 32 über eine nicht gezeigte Schraube als Befestigungsmittel kraftschlüssig verbunden werden.

Fig. 2 zeigt eine zweite beispielhafte Ausführungsvariante eines erfindungsgemäßen Befestigungssystems mit einem ersten Adapter 1 und einem zweiten Adapter 2. Ein in Fig. 3 dargestellter dritter Adapter 3 ist ebenfalls Teil des Befestigungssystems.
Im Unterschied zu der in Fig. 1 dargestellten Ausführungsvariante ist der erste Adapter 1 zweiteilig ausgeführt, vertikale Kanten seines ersten Teils und seines zweiten Teils verlaufen parallel zu einer Hochachse 52 und in der Nähe von rückwärtigen, vertikalen Seitenkanten eines elektronischen Geräts 42. Der erste Teil und der zweite Teil sind über eine erste Verbindungsplatte 56 und eine zweite Verbindungsplatte 57 miteinander verbunden. Zwischen der ersten Verbindungsplatte 56 und dem ersten Adapter 1 sowie der zweiten Verbindungsplatte 57 und dem ersten Adapter 1 sind jeweils vier Schraubenverbindungen angeordnet. Die erste Verbindungsplatte 56 ist in einem unteren Bereich des elektronischen Geräts 42 angeordnet, die zweite Verbindungsplatte 57 in einem oberen Bereich.
Der erste Adapter 1 umfasst eine erste Nutenlasche 4, eine zweite Nutenlasche 5, eine dritte Nutenlasche 6, eine vierte Nutenlasche 7 sowie weitere Nutenlaschen, die rechteckige Konturen mit abgerundeten Ecken aufweisen.

Der zweite Adapter 2 umfasst eine erste Führungslasche 12 mit einem ersten Führungsbolzen 17, eine zweite Führungslasche 13 mit einem zweiten Führungsbolzen 18, eine dritte Führungslasche 14 ohne Führungsbolzen, eine vierte Führungslasche 15 ohne Führungsbolzen sowie weitere Führungslaschen mit weiteren Führungsbolzen und weitere Führungslaschen ohne Führungsbolzen.
Die erste Führungslasche 12, die zweite Führungslasche 13, die dritte Führungslasche 14, die vierte Führungslasche 15 sowie die weiteren Führungslaschen weisen rechteckige Konturen mit abgerundeten Ecken auf.

Mit der ersten Verbindungsplatte 56 ist ein Hebel 46 verbunden, der teilweise zwischen dieser sowie dem zweiten Adapter 2 angeordnet ist.
Auf der ersten Verbindungsplatte 56 sind eine erste Kulissenführung 58 und eine zweite Kulissenführung 59 angeordnet, über welche der Hebel 46 von einer eingeklappten in eine ausgelenkte Stellung und umgekehrt übergeführt werden kann.
Der Hebel 46 weist eine Pulverbeschichtung in leuchtend grüner Farbe auf.

Fig. 2 zeigt eine ausgelenkte Stellung des Hebels 46, wobei dieser vertikal nach unten ragt. In einem unteren Bereich des Hebels 46 ist eine sechste Bohrung 38 angeordnet, über welche, wie in Fig. 7 dargestellt, der Hebel 46 mit einer ersten Wand 43 befestigt und der erste Adapter 1 arretiert werden kann.
Auf einer Unterseite des elektronischen Geräts 42 sind ein erstes Profil 44 und ein zweites Profil 45 angeordnet und über teilweise dargestellte Schraubenverbindungen mit dem elektronischen Gerät 42 verbunden. Das erste Profil 44 kann in eine nicht gezeigte erste Schiene und das zweite Profil 45 in eine nicht gezeigte zweite Schiene eingeführt werden, die das elektronische Gerät 42 und das Befestigungssystem stützen. Die erste Schiene ist an einer ebenfalls nicht gezeigten zweiten Wand und die zweite Schiene an einer nicht dargestellten dritten Wand eines Geräteschranks in einer Weise angeordnet, dass bei einem Einführen des elektronischen Geräts 42 in den Geräteschrank der erste Adapter 1 und der zweite Adapter 2 zu dem in Fig. 3 gezeigten, mit einer ersten Wand 43 des Geräteschranks verbundenen dritten Adapter 3 vertikal passend ausgerichtet sind. Diese passende Ausrichtung bewirkt, dass ein erster Sicherungsbolzen 22, ein zweiter Sicherungsbolzen 23 sowie weitere Sicherungsbolzen zwischen der ersten Nutenlasche 4 und der ersten Führungslasche 12, der zweiten Nutenlasche 5 und der zweiten Führungslasche 13, der dritten Nutenlasche 6 und der dritten Führungslasche 14, der vierten Nutenlasche 7 und der vierten Führungslasche 15 sowie zwischen weiteren Nutenlaschen und weiteren Führungslaschen angeordnet sind und das elektronische Gerät 42 in dem Geräteschrank arretiert werden kann.

In Fig. 2 wird ein Montagezustand gezeigt, in dem der erste Adapter 1 gegenüber dem zweiten Adapter 2 über den Hebel 46 in einer Weise vertikal nach oben verschoben wurde, dass der nicht dargestellte erste Sicherungsbolzen 22 zwischen der ersten Nutenlasche 4 und der ersten Führungslasche 12 in einer auf der ersten Nutenlasche 4 ausgebildeten ersten Ausnehmung 25, der nicht dargestellte zweite Sicherungsbolzen 23 zwischen der zweiten Nutenlasche 5 und der zweiten Führungslasche 13 in einer auf der zweiten Nutenlasche 5 ausgebildeten zweiten Ausnehmung 26, sowie die weiteren nicht dargestellten Sicherungsbolzen zwischen weiteren Nutenlaschen und weiteren Führungslaschen in weiteren Ausnehmungen angeordnet sein können.
In diesem Zustand ist das elektronische Gerät 42 gegen unbeabsichtigte Bewegungen gesichert.

Im Übrigen entsprechen das in Fig. 2 gezeigte Prinzip und die gewählten Bezugszeichen jener Ausführungsvariante, die in Fig. 1 dargestellt ist.

Fig. 3 zeigt einen Schrägriss einer beispielhaften Ausführungsvariante eines dritten Adapters 3 eines erfindungsgemäßen Befestigungssystems, wie es z.B. in Fig. 1 und in Fig. 2 dargestellt ist, sowie einen Ausschnitt einer ersten Wand 43.
Der dritte Adapter 3 umfasst eine dritte Grundplatte 49 eine erste Seitenplatte 50 sowie eine zweite Seitenplatte 51, die in einem Winkel von 90° zu der dritten Grundplatte 49 ausgerichtet sind. Der dritte Adapter 3 weist einen U-förmigen Querschnitt auf. Auf der dritten Grundplatte 49 sind eine erste Schlüssellochausnehmung 60 sowie weitere Schlüssellochausnehmungen ausgebildet. Die erste Wand 43 umfasst eine siebente Bohrung 39, die sich mit der ersten Schlüssellochausnehmung 60 überlappt sowie weitere Bohrungen, die sich mit weiteren Schlüssellochausnehmungen überlappen. Über die erste Schlüssellochausnehmung 60, die weiteren Schlüssellochausnehmungen sowie die siebente Bohrung 39 sowie weitere Bohrungen wird der dritte Adapter 3 mit der ersten Wand 43 über nicht dargestellte Schraubenverbindungen verbunden.
Auf der ersten Seitenplatte 50 sind ein erster Sicherungsbolzen 22 sowie weitere Sicherungsbolzen angeordnet, auf der zweiten Seitenplatte 51 ein zweiter Sicherungsbolzen 23 sowie ebenfalls weitere Sicherungsbolzen. Der erste Sicherungsbolzen 22, der zweite Sicherungsbolzen 23 sowie die weiteren Sicherungsbolzen sind parallel zu einer Querachse 53 ausgerichtet.
In einem Bereich zwischen der ersten Seitenplatte 50 und der zweiten Seitenplatte 51 sind nicht dargestellte Leitungen eines ebenfalls in Fig. 3 nicht gezeigten elektronischen Geräts 42 angeordnet.

In den dritten Adapter 3 werden der in Fig. 1 und Fig. 2 dargestellte erste Adapter 1 und der zweite Adapter 2 eingeführt. Für eine Arretierung eines elektronischen Geräts 42 wird, wie im Zusammenhang mit Fig. 1 und Fig. 2 beschrieben, der erste Adapter 1 gegenüber dem zweiten Adapter 2 in einer Weise verschoben, dass am Ende dieses Bewegungsvorgangs der erste Sicherungsbolzen 22 in einer erste Ausnehmung 25, der zweite Sicherungsbolzen 23 in einer zweiten Ausnehmung 26 sowie die weiteren Sicherungsbolzen in weiteren Ausnehmungen angeordnet sind.

Fig. 4 zeigt Seitenrisse der in Fig. 1 dargestellten ersten beispielhaften Ausführungsvariante eines erfindungsgemäßen Befestigungssystems, wobei in drei Abbildungen je ein Zustand eines beispielhaften, erfindungsgemäßen
Arretierungsverfahrens gezeigt wird.
Ein erster Adapter 1 weist eine zweite Nutenlasche 5 mit einer zweiten Nut 9, eine vierte Nutenlasche 7 mit einer vierten Nut 11 sowie weitere Nutenlaschen mit weiteren Nuten auf. Weiterhin ist auf dem ersten Adapter 1 eine zweite Sicherungslasche 30 mit einer vierten Bohrung 36 angeordnet. Der erste Adapter 1 grenzt an einen zweiten Adapter 2, der eine zweite Führungslasche 13 mit einem zweiten Führungsbolzen 18, eine vierte Führungslasche 15 mit einem vierten Führungsbolzen 20 sowie weitere Führungslaschen mit weiteren Führungsbolzen aufweist.
Weiterhin umfasst der zweite Adapter 2 eine vierte Sicherungslasche 32 mit einer fünften Bohrung 37, die fluchtend mit der zweiten Sicherungslasche 30 und der vierten Bohrung 36 angeordnet ist.
Über eine erste Verbindungslasche 55 sowie weitere Verbindungslaschen ist der zweite Adapter 2 mit einem elektronischen Gerät 42 verbunden.

Die linke bzw. unterste Abbildung zeigt einen ersten Zustand des erfindungsgemäßen Arretierungsverfahrens, bei dem ein zweiter Sicherungsbolzen 23 eines in Fig. 3 dargestellten dritten Adapters 3 zwischen der zweiten Nutenlasche 5 sowie der vierten Nutenlasche 7 und weitere Sicherungsbolzen zwischen weiteren Nutenlaschen angeordnet sind. Die zweite Sicherungslasche 30 berührt die vierte Sicherungslasche 32 nicht. Der zweite Führungsbolzen 18 ist in einem oberen Bereich der zweiten Nut 9 angeordnet, der vierte Führungsbolzen 20 in einem oberen Bereich der vierten Nut 11 und die weiteren Führungsbolzen in oberen Bereichen der weiteren Nuten.

Die mittlere Abbildung stellt einen Zustand dar, in dem der zweite Sicherungsbolzen 23 zwischen der zweiten Nutenlasche 5, der vierten Nutenlasche 7 sowie einer ersten Grundplatte 47 des ersten Adapters 1 und die weiteren Sicherungsbolzen zwischen weiteren Nutenlaschen sowie der ersten Grundplatte 47 des ersten Adapters 1 angeordnet sind.
Im Übrigen entspricht dieser Zustand jenem der linken Abbildung.

Die rechte bzw. oberste Abbildung zeigt einen Zustand, in dem sich das elektronische Gerät 42 mit dem zweiten Adapter 2 aufgrund von Gewichtskräften im Vergleich zu der linken und der mittleren Abbildung vertikal nach unten bewegt hat und von dem zweiten Sicherungsbolzen 23 sowie den weiteren Sicherungsbolzen gehalten wird.
Der zweite Führungsbolzen 18 ist in einem unteren Bereich der zweiten Nut 9 angeordnet, der vierte Führungsbolzen 20 in einem unteren Bereich der vierten Nut 11 und die weiteren Führungsbolzen in unteren Bereichen der weiteren Nuten.
Der zweite Sicherungsbolzen 23 ist zwischen der zweiten Nutenlasche 5, der vierten Nutenlasche 7, der zweiten Führungslasche 13 sowie der ersten Grundplatte 47 in einer zweiten Ausnehmung 26 angeordnet, die weiteren Sicherungsbolzen zwischen weiteren Nutenlaschen, weiteren Führungslaschen sowie der ersten Grundplatte 47 in weiteren Ausnehmungen.
Die Breite der zweiten Ausnehmung 26 entspricht dem Durchmesser des zweiten Sicherungsbolzens 23, die Breiten der weiteren Ausnehmungen den Durchmessern der weiteren Sicherungsbolzen.

Die zweite Sicherungslasche 30 berührt die vierte Sicherungslasche 32. Über ein nicht dargestelltes Befestigungsmittel (z.B. eine Schraube) kann die zweite Sicherungslasche 30 mit der vierten Sicherungslasche 32 verbunden und das Befestigungssystem arretiert werden.

Fig. 5 zeigt Schrägrisse einer zweiten beispielhaften Ausführungsvariante eines erfindungsgemäßen
Befestigungssystems, wobei zwei Zustände eines beispielhaften erfindungsgemäßen Arretierungsverfahrens gezeigt werden.
Ein erster Adapter 1 weist eine erste Verbindungsplatte 56 mit einem Hebel 46 auf. Ein zweiter Adapter 2 ist fest mit einem elektronischen Gerät 42 und verschiebbar mit dem ersten Adapter 1 verbunden. Mit einer Unterseite des elektronischen Geräts 42 sind ein erstes Profil 44 und ein zweites Profil 45 verbunden, über die das elektronische Gerät 42 auf nicht dargestellten Schienen in einen ebenfalls nicht gezeigten Geräteschrank eingeführt werden kann.
Die linke Abbildung zeigt einen ersten Zustand, in dem der Hebel 46 eingeklappt und horizontal ausgerichtet ist.
Die rechte Abbildung zeigt einen zweiten Zustand, in dem der Hebel 46 ausgelenkt ist und vertikal nach unten ragend ausgerichtet ist. In diesem zweiten Zustand kann der Hebel 46 über eine darauf angeordnete sechste Bohrung 38 und ein nicht dargestelltes Befestigungsmittel (z.B. eine Schraube) mit einer z.B. in Fig. 7 dargestellten ersten Wand 43 verbunden und das Befestigungssystem arretiert werden.

Fig. 6 zeigt einen Seitenriss einer zweiten beispielhaften Ausführungsvariante eines erfindungsgemäßen
Befestigungssystems, wobei ein Zustand eines beispielhaften erfindungsgemäßen Arretierungsverfahrens dargestellt ist.
Ein erster Adapter 1 umfasst eine dritte Nutenlasche 6 mit einer dritten Nut 10 sowie weitere Nutenlaschen mit weiteren Nuten, ein zweiter Adapter 2 eine dritte Führungslasche 14, eine fünfte Führungslasche 16 mit einem dritten Führungsbolzen 19 sowie weitere Führungslaschen mit und ohne weitere Führungsbolzen.
In dem dargestellten Zustand sind ein dritter Sicherungsbolzen 24 zwischen der dritten Nutenlasche 6 und der dritten Führungslasche 14 in einer vierten Ausnehmung 28 sowie weitere Sicherungsbolzen zwischen weiteren Nutenlaschen und weiteren Führungslaschen in weiteren Ausnehmungen angeordnet.
Die Breite der vierten Ausnehmung 28 entspricht dem Durchmesser des dritten Sicherungsbolzens 24, die Breiten der weiteren Ausnehmungen den Durchmessern der weiteren Sicherungsbolzen.

Ein mit dem zweiten Adapter 2 verbundenes und z.B. in Fig. 2 dargestelltes elektronisches Gerät 42 ist in diesem Zustand gegen unbeabsichtigte Bewegungen gesichert.

Fig. 7 zeigt einen Schrägriss einer zweiten beispielhaften Ausführungsvariante eines erfindungsgemäßen
Befestigungssystems, wobei ein Zustand eines beispielhaften erfindungsgemäßen Arretierungsverfahrens dargestellt ist. Auf einer Unterseite eines elektronischen Geräts 42 sind ein erstes Profil 44 und ein zweites Profil 45 angeordnet.
Ein nicht gezeigter Geräteschrank umfasst eine mit einer zweiten Wand verbundene erste Schiene und eine mit einer dritten Wand verbundene zweite Schiene. Das erste Profil 44 ist in der ersten Schiene, das zweite Profil 45 in der zweiten Schiene angeordnet. Über das erste Profil 44, das zweite Profil 45, die erste Schiene und die zweite Schiene wird das elektronische Gerät 42 in dem Geräteschrank abgestützt.
Ein mit einem z.B. in Fig. 5 dargestellten ersten Adapter 1 verbundener Hebel 46 ist ausgelenkt und ragt vertikal nach unten. Eine erste Wand 43 weist eine achte Bohrung 40 sowie weitere Bohrungen auf. Über eine dieser weiteren Bohrungen, eine z.B. in Fig. 5 dargestellte, auf dem Hebel 46 angeordnete sechste Bohrung 38 als Aufnahme für ein Befestigungsmittel und eine Sicherungsschraube 41 als Befestigungsmittel ist der Hebel 46 mit der ersten Wand 43 verbunden.

In diesem Zustand sind die in Fig. 6 gezeigte Stellung des ersten Adapters 1 gegenüber einem zweiten Adapter 2 fixiert und das Befestigungssystem arretiert.

Bei dem in Fig. 1, Fig. 2, Fig. 5 und Fig. 7 dargestellten elektronischen Gerät 42 handelt es sich um eine günstige Lösung. Erfindungsgemäß ist es jedoch auch vorstellbar, mechanische Vorrichtungen, Automaten etc. mit dem gezeigten Befestigungssystem zu befestigen.

### Liste der Bezeichnungen

- 1: Erster Adapter
- 2: Zweiter Adapter
- 3: Dritter Adapter
- 4: Erste Nutenlasche
- 5: Zweite Nutenlasche
- 6: Dritte Nutenlasche
- 7: Vierte Nutenlasche
- 8: Erste Nut
- 9: Zweite Nut
- 10: Dritte Nut
- 11: Vierte Nut
- 12: Erste Führungslasche
- 13: Zweite Führungslasche
- 14: Dritte Führungslasche
- 15: Vierte Führungslasche
- 16: Fünfte Führungslasche
- 17: Erster Führungsbolzen
- 18: Zweiter Führungsbolzen
- 19: Dritter Führungsbolzen
- 20: Vierter Führungsbolzen
- 21: Fünfter Führungsbolzen
- 22: Erster Sicherungsbolzen
- 23: Zweiter Sicherungsbolzen
- 24: Dritter Sicherungsbolzen
- 25: Erste Ausnehmung
- 26: Zweite Ausnehmung
- 27: Dritte Ausnehmung
- 28: Vierte Ausnehmung
- 29: Erste Sicherungslasche
- 30: Zweite Sicherungslasche
- 31: Dritte Sicherungslasche
- 32: Vierte Sicherungslasche
- 33: Erste Bohrung
- 34: Zweite Bohrung
- 35: Dritte Bohrung
- 36: Vierte Bohrung
- 37: Fünfte Bohrung
- 38: Sechste Bohrung
- 39: Siebente Bohrung
- 40: Achte Bohrung
- 41: Sicherungsschraube
- 42: Elektronisches Gerät
- 43: Erste Wand
- 44: Erstes Profil
- 45: Zweites Profil
- 46: Hebel
- 47: Erste Grundplatte
- 48: Zweite Grundplatte
- 49: Dritte Grundplatte
- 50: Erste Seitenplatte
- 51: Zweite Seitenplatte
- 52: Hochachse
- 53: Querachse
- 54: Längsachse
- 55: Erste Verbindungslasche
- 56: Erste Verbindungsplatte
- 57: Zweite Verbindungsplatte
- 58: Erste Kulissenführung
- 59: Zweite Kulissenführung
- 60: Erste Schlüssellochausnehmung

## Patentansprüche

1. Befestigungssystem mit einem ersten Adapter, einem zweiten Adapter und einem dritten Adapter, insbesondere für und verbindbar mit einem elektronischen Gerät, **dadurch gekennzeichnet,**
**dass** der erste Adapter (1) zumindest eine erste Nutenlasche (4) mit einer ersten Nut (8) sowie eine zweite Nutenlasche (5) mit einer zweiten Nut (9) aufweist,
**dass** der zweite Adapter (2) zumindest eine erste Führungslasche (12) mit einem ersten Führungsbolzen (17) sowie eine zweite Führungslasche (13) mit einem zweiten Führungsbolzen (18) aufweist,
**dass** der dritte Adapter (3) zumindest einen ersten Sicherungsbolzen (22) sowie einen zweiten Sicherungsbolzen (23) aufweist,
**dass** in einem zusammengefügten Zustand des ersten Adapters (1) mit dem zweiten Adapter (2) der erste Führungsbolzen (17) in der ersten Nut (8) und der zweite Führungsbolzen (18) in der zweiten Nut (9) angeordnet sind, und
**dass** der zumindest erste Sicherungsbolzen (22) durch die zumindest erste Nutenlasche (4) sowie die zumindest erste Führungslasche (12) und der zweite Sicherungsbolzen (23) durch die zweite Nutenlasche (5) sowie die zweite Führungslasche (13) verriegelbar sind.

2. Befestigungssystem nach Anspruch 1, **dadurch gekennzeichnet, dass** auf der zumindest ersten Führungslasche (12) eine erste Ausnehmung (25) und auf der zweiten Führungslasche (13) eine zweite Ausnehmung (26) angeordnet ist, wobei die erste Ausnehmung (25) eine Breite von größer oder gleich dem Durchmesser des zumindest ersten Sicherungsbolzens (22) und die zweite Ausnehmung (26) eine Breite von größer oder gleich dem Durchmesser des zweiten Sicherungsbolzens (23) aufweist.

3. Befestigungssystem nach Anspruch 1, **dadurch gekennzeichnet, dass** auf der zumindest ersten Nutenlasche (4) eine erste Ausnehmung (25) und auf der zweiten Nutenlasche (5) eine zweite Ausnehmung (26) angeordnet ist, wobei die erste Ausnehmung (25) eine Breite von größer oder gleich dem Durchmesser des zumindest ersten Sicherungsbolzens (22) und die zweite Ausnehmung (26) eine Breite von größer oder gleich dem Durchmesser des zweiten Sicherungsbolzens (23) aufweist.

4. Befestigungssystem nach Anspruch 1, **dadurch gekennzeichnet, dass** die zumindest erste Nutenlasche (4), die zweite Nutenlasche (5), die zumindest erste Führungslasche (12) sowie die zweite Führungslasche (13) hakenförmig ausgebildet sind.

5. Befestigungssystem nach Anspruch 1, **dadurch gekennzeichnet, dass** der erste Adapter (1) eine dritte Nutenlasche (6) und eine vierte Nutenlasche (7) aufweist.

6. Befestigungssystem nach Anspruch 1, **dadurch gekennzeichnet, dass** der zweite Adapter (2) eine dritte Führungslasche (14) und eine vierte Führungslasche (15) aufweist.

7. Befestigungssystem nach Anspruch 1, **dadurch gekennzeichnet, dass** der erste Adapter (1) zumindest eine erste Sicherungslasche (29) und der zweite Adapter (2) zumindest eine dritte Sicherungslasche (31) aufweist, wobei die zumindest erste Sicherungslasche (29) und die zumindest dritte Sicherungslasche (31) Aufnahmen für ein Befestigungsmittel aufweisen.

8. Befestigungssystem nach Anspruch 1, **dadurch gekennzeichnet, dass** der zweite Adapter (2) mit dem insbesondere elektronischen Gerät (42) lösbar verbunden ist.

9. Befestigungssystem nach Anspruch 1, **dadurch gekennzeichnet, dass** der dritte Adapter (3) mit einer ersten Wand (43) lösbar verbunden ist.

10. Befestigungssystem nach Anspruch 1, **dadurch gekennzeichnet, dass** in einem Bereich zwischen dem ersten Adapter (1) und dem dritten Adapter (3) Leitungen des insbesondere elektronischen Geräts (42) angeordnet sind.

11. Befestigungssystem nach Anspruch 1, **dadurch gekennzeichnet, dass** das insbesondere elektronische Gerät (42) ein erstes Profil (44) und ein zweites Profil (45) aufweist, wobei das erste Profil (44) in einer ersten Schiene, die lösbar mit einer zweiten Wand verbunden ist, und das zweite Profil (45) in einer zweiten Schiene, die lösbar mit einer dritten Wand verbunden ist, angeordnet ist.

12. Befestigungssystem nach Anspruch 1, **dadurch gekennzeichnet, dass** mit dem ersten Adapter (1) ein Hebel (46) verbunden ist, der eine Aufnahme für ein Befestigungsmittel aufweist.

13. Befestigungssystem nach Anspruch 12, **dadurch gekennzeichnet, dass** der Hebel (46) in einer Signalfarbe ausgeführt ist.

14. Verfahren für die Arretierung eines Befestigungssystems nach einem der Ansprüche 1, 2, 4, 5, 6, 7, 8, 9 oder 10, **dadurch gekennzeichnet,**
**dass** der erste Adapter (1) mit dem zweiten Adapter (2) in einer Weise in den dritten Adapter (3) eingeführt wird, dass am Ende dieses Vorgangs die zumindest erste Nutenlasche (4) an dem zumindest ersten Sicherungsbolzen (22) und die zweite Nutenlasche (5) an dem zweiten Sicherungsbolzen (23) hängt, dass der zweite Adapter (2), der erste Führungsbolzen (17) in der ersten Nut (8) sowie der zweite Führungsbolzen (18) in der zweiten Nut (9) sich in einer Weise bewegen, dass am Ende dieses Bewegungsvorgangs der zumindest erste Sicherungsbolzen (22) zumindest zwischen der zumindest ersten Nutenlasche (4) sowie der zumindest ersten Führungslasche (12) in der ersten Ausnehmung (25) und der zweite Sicherungsbolzen (23) zumindest zwischen der zweiten Nutenlasche (5) sowie der zweiten Führungslasche (13) in der zweiten Ausnehmung (26) angeordnet ist, und
**dass** mit einem Befestigungsmittel die zumindest erste Sicherungslasche (29) mit der dritten Sicherungslasche (31) lösbar verbunden wird.

15. Verfahren für die Arretierung eines Befestigungssystems nach einem der Ansprüche 1, 3, 5, 6, 8, 9, 10, 11, 12 oder 13, **dadurch gekennzeichnet,**
**dass** der erste Adapter (1) mit dem zweiten Adapter (2) über das erste Profil (44) und die erste Schiene sowie das zweite Profil (45) und die zweite Schiene in den dritten Adapter (3) eingeführt wird,
**dass** der Hebel (46) in einer Weise ausgelenkt, der erste Adapter (1) in einer Weise verschoben wird und der erste Führungsbolzen (17) in der ersten Nut (8) sowie der zweite Führungsbolzen (18) in der zweiten Nut (9) sich in einer Weise bewegen, dass am Ende dieses Bewegungsvorgangs der zumindest erste Sicherungsbolzen (22) zumindest zwischen der zumindest ersten Nutenlasche (4) sowie der zumindest ersten Führungslasche (12) in der ersten Ausnehmung (25) und der zweite Sicherungsbolzen (23) zumindest zwischen der zweiten Nutenlasche (5) sowie der zweiten Führungslasche (13) in der zweiten Ausnehmung (26) angeordnet ist, und
**dass** mit einem Befestigungsmittel der Hebel (46) und die erste Wand (43) miteinander lösbar verbunden werden.
